# EUROPEAN PATENT SPECIFICATION

(11) **EP 0 539 555 B1**
(45) Date of publication and mention of the grant of the patent: **10.04.1996**
(21) Application number: 92909972.9
(22) Date of filing: 05.05.1992
(51) Int. Cl.: H01L 23/02, H01L 23/16, H01L 21/54

(54) **ARRANGEMENT FOR ENCASING A FUNCTIONAL DEVICE, AND A PROCESS FOR THE PRODUCTION OF SAME**
GEHÄUSEANORDNUNG FÜR EIN FUNKTIONALES BAUELEMENT UND HERSTELLUNGSVERFAHREN
CONFIGURATION POUR LA MISE EN BOITIER D'UN DISPOSITIF FONCTIONNEL, ET PROCEDE POUR SA FABRICATION

(30) Priority: 06.05.1991 NO 911774
(43) Date of publication of application: 05.05.1993
(73) Proprietor: SENSONOR A.S., N-3190 Horten (NO)
(72) Inventor: KVISTEROY, Terje, N-3190 Horten (NO); JACOBSEN, Henrik, N-3190 Horten (NO)
(74) Representative: Perklev, Karin Cecilia
(86) International application number: NO9200085
(87) International publication number: WO9220096

(56) References cited:
- EP-A- 0 216 352
- EP-A- 0 421 005
- GB-A- 2 176 936
- US-A- 4 801 998
- US-A- 4 961 106

## Description

The present invention relates to an arrangement for encasing a functional device, wherein the casing forms at least one closed cavity which wholly or partly surrounds the functional device, wherein metal conductors pass through the walls of the casing and form conductive connections to the encased said functional device, and wherein the cavity is sealed and filled with an electrically insulating fluid. Further, the invention comprises a process for the production of an arrangment of this kind, wherein the casing is formed by two or more components which, when put together, form at least one cavity, wherein electrical conductors of metal are built into the casing, e.g., a leadframe which has a portion which projects outside the casing when the components are assembled, wherein the functional device is attached to the side of the cavity on one of the components prior to said components being secured to one another, wherein electrical terminals on the functioning body are attached to said respective conductors within the area of the cavity prior to said components being secured to one another, wherein the components are connected to one another in such a way that they are sealed, eg, by means of gluing or welding, wherein the electrically insulating fluid is inserted into the cavity through filling holes in an adjoining casing component, and wherein the filling holes are sealed closed to that the cavity is totally sealed.

In connection with the present invention, the functional device may, for instance, be a semiconductor element, a semiconductor-based element, a sensor element, a microactuator, or an electronic circuit comprising one or several integrated circuits and other electronic components.

The encasing of functional devices, e.g., semiconductor elements such as integrated circuits, is previously known. Normally this happens without the use of a cavity or hollow space around parts of the functional device.

However, solutions are also known wherein functional devices of this kind are encased in a plastic material, or a metal material, or a combination thereof, and having a cavity wholly or partly surrounding the functional device. Such solutions are known from, inter alia, US Patent Nos. 4961106 and 4801998, EP Patent Publications 421005-A3 and 216352-A3 and GB Patent Publication 2176936-A.

An arrangement is known from US Patent No. 4961106 wherein the casing is made of metal with insulators of glass arranged around the contact pins of the functional device where these are led through the wall of the casing. A solution of this kind gives rise to high production costs and no possiblity of an automated process. The glass must have an expansion coefficient equal to that of the metal, and melting the glass takes place at a high temperature in a throughput furnace. The cavity is sealed by means of a sealant between the cup body of the casing and the lid thereof. The cavity is filled with a gel or a liquid, but can with difficulty be completely filled without a considerable rupture effect. This is due, inter alia, to the fact that there are no walls which can accommodate the expansion. The solution is therefore most suitable for high quality power components where the price is of little significance.

US Patent No. 4801998 relates to an EPROM device which is "tailor-made" for the UV-based erasing of EPROM. Encasing takes place in that EPROM is arranged on a printed circuit board, and that over this assembly is placed a cap of a UV-transparent material, after a ITV-transmitting silicone resin has first been placed on the top of said EPROM, and that the remaining cavity is thereafter filled with a second silicone resin via filling holes in said cap. Here, there is no diaphragm solution present and the filling material is cured by heating. A substantial restriction is that the solution can only be used in the art of circuit boards.

EP Patent Publication 421005-A3 describes a casing of metal around an electronic device. A closed cavity is formed by means of two heat sink metal bodies, eg, plates, which are secured to one another by means of at least two separate sealing means. The leadframe is placed between the sealing means with connection to the electronic device. The assembly is complicated, time-consuming and also, therefore, expensive.

EP Patent Publication 216352-A3 discloses a device for compensating for mechanical tensions in solder bumps between thick-layer circuit boards which have a conductive pattern and an integrated circuit. This assembly is surrounded by a casing of metal or plastic which is in the form of a cup with a flat lid. A sealing material in the form of silicone gel is arranged over and around the assembly, whereupon either resin or air is disposed thereupon. Thereafter, the lid is fastened to the cup by means of a silicone adhesive of the reaction type. The silicone gel will penetrate in between the gap which exists between the integrated circuit and the circuit board, in addition to the fact that it will fill only a part of the cavity. The assembly process is demanding and is meant to solve only one specific problem in connection with solder bumps.

GB Patent Publication 2176936-A relates to a casing for a power semiconductor, wherein the casing consists of a heat-sink metal plate on which the power semiconductor is arranged via an electrically insulating plate, and an a hood which together with the metal plate forms a cavity, said cavity being sealed with a rigid resinous material which simultaneously supports and insulates the electrical conductors of the semiconductor. The cavity can, prior to being sealed, be filled with a gel substance, eg, gel resin. The hood may be made of metal, plastic or ceramics.

In electronic components, power discharge is often a major problem. To equip plastic casings with heat-sinks or to mount the plastic casings on a heat-sink is known.

Apart from thermally induced malfunctions which will occur no matter what kind of casing is used (so-called purple plague, accumulation of surface charges, electro-migration), the plastic casing will give rise to a number of special faulty mechanisms.

On cooling the moulded mass, great mechanical tensions will be formed at the junction between the silicon and the plastic. This may result in the destruction of wire bonds, great, undesirable tension in the silicon or a complete slip between the silicon and the plastic. This is usually improved upon by means of a flexible passivation layer or by using "low stress" material.

The mechanism which results in corrosion or other moisture-dependent processes can be divided up into four steps:
1. Water penetrates through the plastic casing. Water will normally penetrate through a plastic casing in the course of hours/days, and it ought to be noted here that there is no direct connection between water absorption and permeability.
2. The diffusion of moisture in bulk or defects in passivation which are of such a nature that the moisture reaches the metallizing (or possibly function-sensitive area).
3. The moisture acts as an electrolyte for remaining impurities from the production or substances from the plastic, e.g., ionic transport to areas exposed to corrosion.
4. Electrochemical reactions. The composition of plastic materials can, to a great extent, effect the rate of reaction in these processes.

The fillers in a plastic material can be a source of alpha particles and can cause problems for integrated circuits of the memory kind. It is therefore common practice to protect the actual electronic chip with a thin layer of polyimide.

It is also common practice to use a number of tests in order to assess the reliablity of the components encased in plastic. A first trpe of test reveals problems with the actual chip, such as oxide defects and electro-migration. A second type of test can be a temperature test which may reveal, for instance, mechanical problems. A third test reveals, in the first place, chlorine-induced corrosion of bonding areas and aluminium wiring.

Today, approximately 85% of all integrated circuits are encased in plastic. There are, therefore, no fundamental reliability problems, and plastic encasing is carried out, as a rule, completely automatically and gives the possibility of great reliability for the individual casing. However, it is essential thrat the encased functional device is able to operate reliably under most field conditions, and not under the theoretical conditions which reign in a laboratory. The need for reliability must therefore be given top priority. In general, the encasing of a functional device shall provide protection against the surrounding environment, provide electrical connection from the functional device, e.g., an electronic hip, to the surrounding circuits, and provide a thermal coupling from the functional device to the surrounding environment. Here, no one factor is decisive. Usually special consideration has to be accorded to low wire capacitance and inductance, sufficiently low level of mechanical tension in the materials, good material combatability, low thermal resistance, low leakage, high reliability, simple method of production, and low costs.

When using plastic in connection with a common plastic-moulded integrated circuit, the plastic will serve as a barrier against the surrounding environment, and here moisture in the surrounding environment has been accorded special concentration. However, polymer materials are not hermetically sealed, and water would be able to penetrate in after some time. In addition to transport via bulk-polymer, there is also transport along the metal-plastic junction. It is the shrinkage effect after moulding that, in the main, provides good sealing along these junctions. Both mechanical and chemical methods can be used to obtain an improvement in the connection between plastic and metal. The metal forms electrical connections with the functional device inside the plastic casing. These metal parts can be of various materials, but preferably an alloy, e.g., nickel, iron or copper based alloys. By using, for instance, a copper alloy, good electrical and thermal conductivity will be attained, whilst the thermal expansion coefficient accords well with a number of plastic materials. However, a large difference in the expansion coefficient in relation to silicon can cause problems when mounting a circuit chip. It will often be common practice to use some form or another of leadframe in order to form said metallic connections with the functional device. A leadframe of this kind has as its task, inter alia, to form a support system, to form a barrier against plastic which can seep out between the wires during the moulding process, to form an attach substrate for the electronic chip and a support die for the plastic material, whilst it also forms an electrical and thermal conductor from the functional device or chip to the surrounding environment. Leadframes of this kind are normally made by means of chemical etching or by mechanical stamping.

In connection with the encasing of integrated circuits, today thermosetting plastics are used almost exclusively. This is possibly due to history, as moulding properties for a number of thermosetting plastics were extremely good at the time this started (at the end of the fifties and the beginning of the sixties) . There has, however, been a whole host of reliability problems connected to encasing through the years, but plastic materials have steadily been improved so that today there is a well developed system.

Thermosetting plastics are simple to mould, and are stable in form during and after the actual moulding process. Novalac-based epoxy mixtures are used most often, optionally with a number of additives.

The use of silicone-based materials has also been known as the mechanical properties thereof are excellent and the temperature of use can be made higher, but the use of these materials has not gained much application because silicone traditionally bonds badly with other materials, for example, the metal in the leadframe. The use of silicone today is, in the main, restricted to putting a drop on top of integrated circuits as extra protection prior to moulding in epoxy. The prior art is also to dose silicone gel over integrated circuits prior to a lid optionally being put on in the different kinds of cavity casings.

Thermoplastics have undergone a creat development and new materials are constantly being launched. Thermoplastics of this kind, more often than not, have excellent electrical and mechanical properties, and the temperature of use is often higher than that of epoxy materials. A further advantage with thermoplastics is a faster production time, lower moulding pressure, and possibilities for recycling the excess material. Thermoplastic materials have also enabled completely new design possibilities, such as snap-on solutions for mounting as well as possibilities of welded joints. However, its dimensional stability can be poorer than that of thermosetting plastics. There are also two difficult factors which mean that thermoplastics are usually not used for encasing wire-bonded integrated circuits, even though thermoplastics are used to a great extent in electrical systems in general, viz., thermoplastics have a high viscosity which can result in wire scan, i.e., disturbances of the wire bonds in connection with the actual moulding process, and low adhesive powers to the fillers and the leadframe. The last-mentioned can, however, be optimized by a certain chemical treatment.

In recent years, the use of liquid crystal polymers (LCP) has been proposed for encasing integrated circuits. Typical for these materials is that the chain molecules contain rigid sequences of a certain minimum length, and it is possible to produce strongly orientated structures with good resistance properties in the longitudinal direction. This special orientation allows good sealing properties to be obtained in one direction. However, the use of LPC material of this kind is still at the research stage. There will, therefore, be many considerations to be made in order to arrive at the best possible solution. There will be a clear consideration between the available materials, the demands which will be made on the final product, the costs of the production equipment, the rate of production and the costs of the mouldeding apparatus. The volume of production must also clearly be taken into account.

Injection moulding is the most common mould moulding for thermoplastics for electrical purposes.

Transfer moulding is used almost without exception for the mould moulding of thermosetting plastics, where the molten mass is plastified and transferred by means of compressed pressure to the mould, and where the mould is kept closed until the cross-link reaction has been completed.

If the jointing method is used, gluing will be used to a great extent either because structural advantages are thereby obtained, the strongest joints are thus obtained, or because it is the only possibility. Thermoplastic glue, thermosetting plastic glue and rubber glue may be used for this purpose.

For thermoplastics, welding can be carried out in several different ways, such as by means of hot gas, hot wire, inductively, by ultra sonics, by means of lasers or friction welding by rubbing. Ultrasonic welding is the most suitable as the temperature can be controlled accurately whilst the welding area is well defined.

The composition of the plastic and the nature of the surface are of great significance for both welding and gluing.

A mechanical joining can be carried out by means of, for example, screwing, or for soft thermoplastics by means of, for example, snap-on connections.

A part of the complex of problems which is connected to the known solutions is aimed to be solved by means of the assembly and process in the present invention.

The known invention referred to by way of introduction is characterized according to the invention in that the casing is made of a thermoplastic, and that at least parts of the walls around the cavity are made so as to be compliant in order to be able to accommodate expansion forces from the said insulating fluid, or that a body in the form of a diaphragm or an elastomer is incorporated in the cavity in order to accommodate said expansion forces. The use of thermoplastic gives rise to simple and fast production, which in turn provides a reasonably priced, yet technically good product, as will also be made apparent in the specification hereinbelow. Further, the form of the walls around the cavity gives rise to the advantage that it easily compensates for changes in temperature which is essential in a casing of this kind.

According to an embodiment of the device, the cavity can be sealed by sealing one or several filling holes or filling ducts, after the volume of the cavity is filled with a liquid and/or a gel. The sealing can, in contrast to the known art, be carried out, for instance, by means of melting, thermal welding or friction welding of the material around the filling hole over a part of the length thereof by means of the local application of heat.

The material which thus fills the cavity will protect the functional device, at the same time as a good thermal connection is provided between the functional device and the casing and the metallic conductors which project into the casing. Thus good heat-sink away from the functional device to the surroundings is achieved and the wire bonds between the metal parts which project out through the walls of the casing, and the functional device is subjected to a minimum of stress during the encasing process. A particular problem with completely liquid filled cavities is the potentially high pressure which could arise because of the difference in thermal expansion between the filler liquid and the material in the casing. This can result in a rupture in the wall and subsequent leakage. In metal cases, the prior art is to use flexible diaphragms in the wall of the casing in order to accommodate the change in volume which occurs during thermal expansion. In the invention described herein, this can be done by moulding a thin area in one or more of the walls of the casing which can accommodate the liquid expansion and thereby prevent ruptures and leakage, as is mentioned above.

The method mentioned by way of introduction is characterized according to the invention in that the components of the casing are made of a thermoplastic material, and that at least parts of the walls around the cavity are compliant so as to be able to accommodate expansion forces from said electrically insulating fluid, or that a body in the form of a diaphragm or elastomer is built into the cavity for the accommodation of said expansion forces.

According to additional embodiments of the method, the filling holes are sealed by means of thermal welding or friction welding. Heat welding can take place by means of the local application of heat around the filling hole, eg, by means of a welding iron. As an alternative, the filling hole can be sealed by means of a sealing screw, a sealing bolt or a sealing ball, optionally in combination with an accompanying gasket.

It is essential that the mechanical properties of the casing are such that it has a strength which is sufficient that it cannot be daraged, nor that the functional device can be damaged during normal handling.

It will be expedient for the functional device to be soldered to the leadframe, if one is used, after the leadframe has been moulded in the plastic material. This requires that the plastic material is able to tolerate typical soldering temperatures, for example, 240° C to 280° C.

An alternative solution is that the functional device is soldered or all yed to the leadframe and that a plastic casing is thereafter attached around the functional device. A further possibility is to use so-called epoxy die-attach which allows for the use of low temperatures. The material which fills the cavity in the casing will function as a water displacing insulation and corrosion protection, whilst the material serves to support the functional device in the cavity.

In order to be able to achieve the arrangement according to the invention, it is generally desirable to be able to use the said welding method in order to seal the casing, as this will give rational production and increase repeatability and reliability. The possibilitie for snap-on connections between the parts which constitute the casing would increase assembly flexibility. This will mean that it is expedient to select a thermoplastic.

Still further embodiments of the arrangement and process according to the invention will be made apparent in the patent claims hereinbelow, as well as in the specification hereinbelow with reference to the enclosed diagrams.

In particular, the present invention could be used for liquid-damped accelerometers. The invention is also suitable for pressure transducers with a dividing diaphragm and an oil or a liquid filling between the dividing diaphragm and the sensor member. Different forms of measuring absolute pressure, relative pressures in respect of the atmosphere and differential pressures with the dividing diaphragm and oil or liquid filling against two pressure media will be possible, but the last-mentioned two cavities with the measuring diaphragm of the functional device as the division between the diaphragms. The invention is also especially suitable for power components, ie, special high power semiconductors. The invention is also most suitable for encasing integrated circuits. Further, the invention can, with advantage be used on multi-chip modules which must be liquid cooled, comprising circuits of large area (up to the size of a circuit board), and optionally also in several layers.

In the present invention, an increased reliability is provided by using a plastic casing, especially because the problems of indiffusion of moisture is reduced. This problem and the requirement of high material purity is still a major problem within the field of plastic encasing of functional devices.

The invention also makes possible low production costs, especially in larger production series and automated production. On using the present invention for pressure sensors which have a dividing diaphragm and a body of thermoplastic, great capability of resistance is attained against a number of corrosive pressure media/environments.

The invention shall be explained in more detail with reference to the enclosed diagrams which illustrate preferred, but for the invention, non-limitative embodiment examples. It will immediately be understood that modifications of the process and the arrangements which are depicted and described herein could be carried out without deviating from the idea and scope of the invention, as it is defined in the patent claims hereinbelow.

Figure 1 illustrates a first embodiment of the process according to the invention.

Figure 2 illustrates a second embodiment of the process according to the invention.

Figure 3 illustrates different methods of sealing the cavity in a casing, according to the invention.

Figure 4 illustrates a first embodiment of the arrangement according to the invention.

Figure 5 illustrates a second embodiment of the arrangement according to the invention.

Figure 6 illustrates a third embodiment of the arrangement according to the invention.

Figure 7 illustrates a fourth embodiment of the arrangement according to the invention.

Figure 8 illustrates a fifth embodiment of the arrangement according to the invention.

Figure 9 illustrates a sixth embodiment of the arrangement according to the invention.

Figure 10 illustrates a seventh embodiment of the arrangement according to the invention, in combination with an integrated circuit.

Figure 11 illustrates an eighth embodiment of the arrangement according to the invention.

Figure 12 illustrates a ninth embodiment of the arrangement according to the invention.

Figure 13 illustrates a tenth embodiment of the arrangement according to the invention.

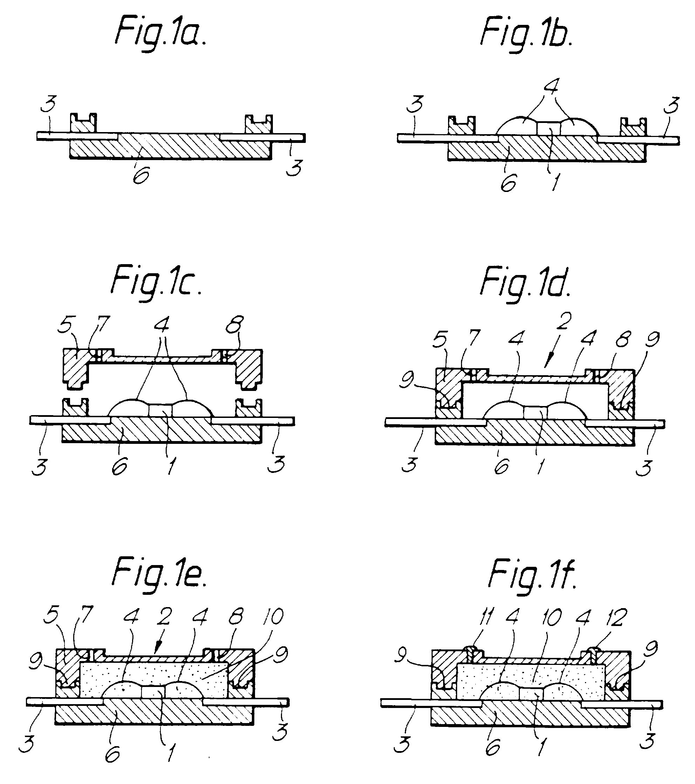

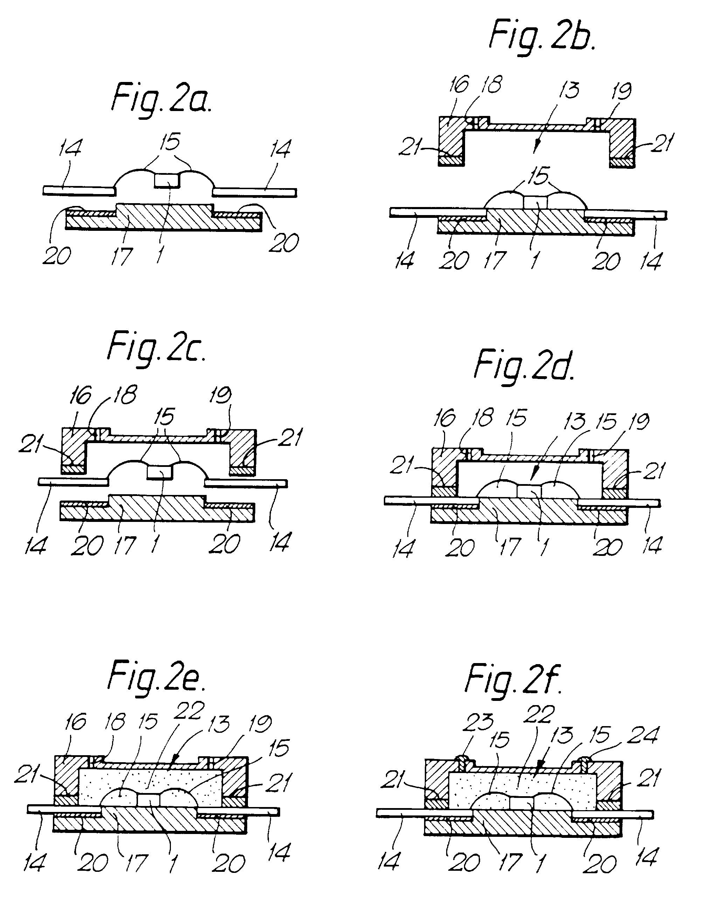

In figure 1, the functional device is marked with the reference numeral 1. From the cavity 2, which is formed in the casing of the functional device 1, metal parts 3 are led out to form wire bonds to the functional device via coupling wires 4. In the embodiment example shown in figure 1, the casing consists of a first component 5 and a second component 6, wherein the said metal parts 3 are moulded beforehand. In the first component 5, there is an infeed hole 7 for the material which is to fill the cavity 2, and there is, moreover, a ventilation hole 8 in the first component 5 in order to ensure that the cavity 2 is filled completely. Filling holes can also optionally be in component 6, or can extend horizontally in component 5. In figure 1, it is shown how the two components 5 and 6 are moulded separately and can be joined together. After the metal parts 3 are moulded into the component 6 (fig. 1a), the functional device 1 is attached by means of wire bonds 4 to the metal parts (fig. 2b) to thereby form electrical connections between the outside of the casing which is to be formed and the functional device. In figs. 1c and 1d the joining of the two components is shown, so that the said cavity 2 is formed. At the junction 9 between the first component 5 and the second component 6, a sealed connection is formed either by means of gluing, welding or a snap-on mechanism. In this connection, ultrasonic welding is mentioned as an expedient method of welding.

The cavity 2 is then filled via the hole 7 with a filling material, expediently a liquid and/or a gel substance. In an embodiment which is not restrictive for the invention, the filling material could, for instance, be a silicone oil. After the filling material has completely filled the cavity 2, inter alia, helped by ventilation through the ventilation hole 8, the holes 7 and 8 will be blocked, as is made apparent from fig. 1f. A blocking or sealing of this kind can take place by melting the material at the holes, or optionally by using sealing screws, sealing bolts or sealing balls. In certain cases, it may be desirable to use gasket in connection with these kinds of sealing means. The sealing means in fig. 1d are indicated by the reference numerals 11 and 12 for holes 7 and 8, respectively.

The metal parts 3 in fig. 1 are made of, for instance, a leadframe which is moulded in the component 6 prior to the components 5 and 6 being assembled.

In fig. 2, the functional device is also denoted by means of the reference numeral 1. The cavity which is to be formed is denoted by the reference numeral 13. The metal parts 14 can expediently be part of a metal frame and the functional device 1 is connected to the metal parts 14 via wire bonds 15 prior to the leadframe being attached to the lower component of the casing 17, shown in fig. 2. The leadframe 14 fits in terms of form to the lower component 17, as is made clear by the drawings. The upper component 16 of the casing is furnished with a filling hole 18 and a ventilation hole 19 for the filling material which is to fill the cavity 13. As in connection with fig. 1, the filling material can be a suitable liquid and/or gel. The leadframe is attached to the lower component 17 by means of glue 20, and the upper component 16 of the casing is connected to the leadframe 14 and the lower casing component 17 by means of glue 21, as said glues 20 and 21 will naturally function together. It would be expedient for glues 20 and 21 to be of exactly the same type. When the joining action, as illustrated in fig. 2c has been completed, a situation such as the one shown in fig. 2d occurs. Here, the cavity 13 is ready to be filled with a filling material, which in figs. 2e and 2f is designated by the reference numeral 22. After the filling material 22 has filled the cavity 13, said cavity 13 is sealed at holes 18 and 19 by means of sealing means, such as by melting the openings of the holes or by using sealing bodies such as sealing screws, sealing bolts or sealing balls, optionally combined with gasket. The sealing bodies for holes 18 and 19 are denoted by the reference numerals 23 and 24, respectively, in fig. 2f.

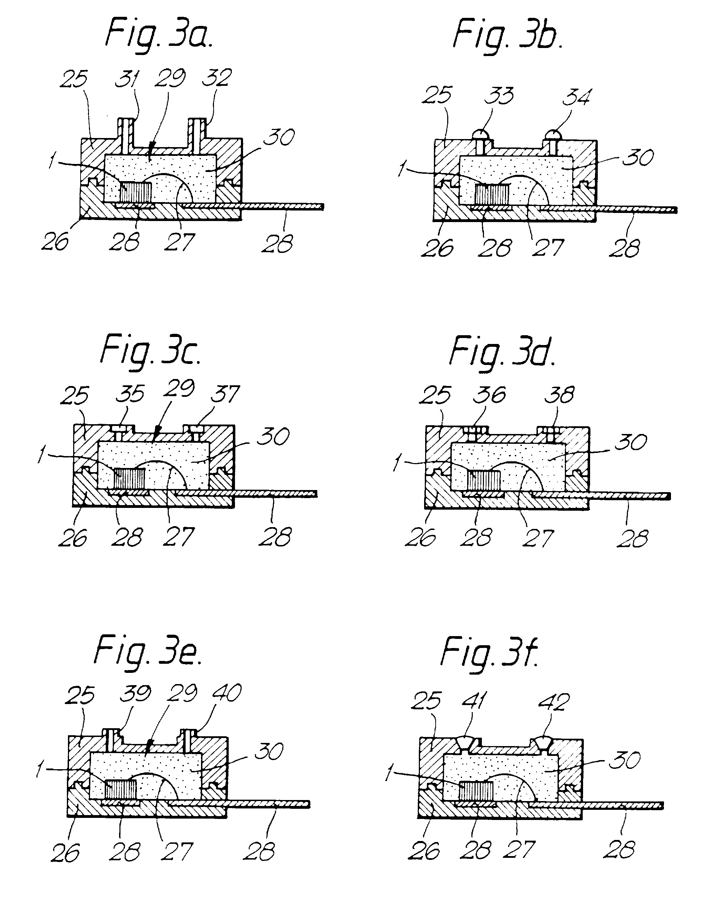

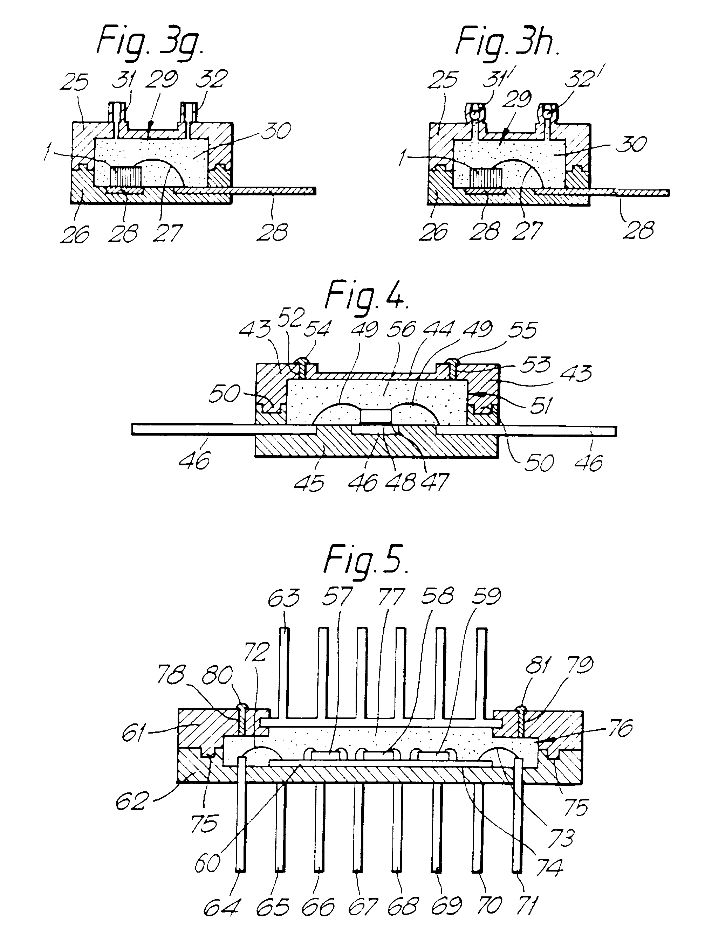

In figure 3, the upper component of the casing is denoted by the reference numeral 25 and the lower component of the casing by the reference numeral 26. Even though the embodiments in figure 3 are shown with upper and lower components joined in accordance with the principles which have been explained in fig. 1, it shall be understood immediately that the joining could have happened in the way which has been explained in connection with fig. 2, where the leadframe is put in the lower component of the casing prior to joining the two components together, instead of moulding in the lower component prior to joining. Here, the cavity is, for the sake of simplicity, denoted by the reference numeral 29 and the leadframe by reference numeral 28. A part of the leadframe 28 supports the functional device thereby providing an enhanced heat-sink connection. To ensure an electrical connection between the functional device 1 and the metal component 28, a wire bond is disposed between these two parts. The filling material 30 is fed in (see fig. 3a) through a filling hole 31 and ventilation takes place via hole 32. After the filling has been completed, the holes 31 and 32 are sealed. The sealing takes place by the sleeves which project up from the filling holes 31 and 32 being either melted or welded to form seals 33 and 34, as is shown in fig. 3b.

In the embodiment which is depicted in figs 3c and 3d, reference numerals 25, 26, 27, 28, 29 and 30 indicate the same elements as in figs 3a and 3b. In this case, instead of filling sleeve 31 and ventilation sleeve 32, two screw holes 35 and 37 respectively, are provided for the filling and ventilation. When the cavity 29 has been filled with the filling material 30, the holes 35 and 37 are sealed by means of sealing screws, optionally with the use of gasket. Such screws may, of course, be self-threading.

A third alternative embodiment for sealing a cavity is illustrated in figs 3e and 3f. Here too, the reference numerals 25-30 and 1 denote the same elements as explained above in connection with figs 3a and 3 b, and 3c and 3d. In this case too, a filling hole 39 and a ventilation hole 40 have been made. After the cavity 29 has been filled with the filling material 30, the area around said holes 39 and 40 is melted to give an area indicated with reference numerals 41 and 42, respectively, wherein the material around the holes 39 and 40 has melted and flowed together to seal said holes 39 and 40. It has been proven in experiments, in spite of great prejudice from those with expertise in the field, that it is possible to melt closed the filling holes by means of applying heat locally and in the presence of a sealant, eg, silicone oil. Here, it would be expedient to use, for instance, a hot iron.

Figs. 3g and 3h show a variant of the solution in figs 3a and 3b. Instead of melting or welding the holes 31 and 32, it is proposed to seal said holes with respective sealing balls 31' and 32'.

The filling of the filling material, eg, liquid or a gel substance can be carried out by filling through the respective filling holes as shown and described in connection with figs 1-3, by making use of a vacuum. The cavity is subjected to a vacuum, whereupon the filling material will easily be sucked into the cavity. The different ways in which this vacuum suction can be carried out will be obvious for a person skilled in the art and does not require further explanation.

In this connection, mention ought to be made of the special conditions which are linked to pressure sensors. In relative transmitters, there will be a pressure inlet which leads into one side of the functional device. Said functional device will then participate in forming the actual cavity in solutions where there is a dividing diaphragm and oil filling on the opposite side of the functional device. In differential pressure sensors it will, on the other hand, be typical to have two cavities which are filled with liquid, one on each side of the diaphragm of the functional device.

As shall be explained in more detail hereinbelow, it would be expedient to attach the functional device to the leadframe in order to ensure the best possible heat-sink action.

After the device according to the invention has been glued together and the cavity, or cavities, has been sealed, the casing of the functional device is washed and unnecessary auxiliary parts are punched away. Thereafter, a function test and a parameter test of the functional device are carried out.

As was mentioned by way of introduction, cavity casings of plastic, especially thermoplastic, are previously known. After mounting the electronic chip or chips, this or these are, as a rule, protected by a silicone gel which shall prevent moisture which penetrates through the walls of the casing from corroding the wiring to the chip or chips. After this, the cavity casing is sealed by a lid being fastened to the main component of the casing, eg, by means of gluing. The introduction of gel, thus, happens prior to the lid being put on. However, there are two disadvantages connected to this, viz., it is a major practical problem to fill the whole cavity, and small amounts of silicone gel which are spilt or flow over onto the sealing surfaces will, as a rule, lead to sealing problems and lack of total sealing.

These are problems which the present invention solves completely.

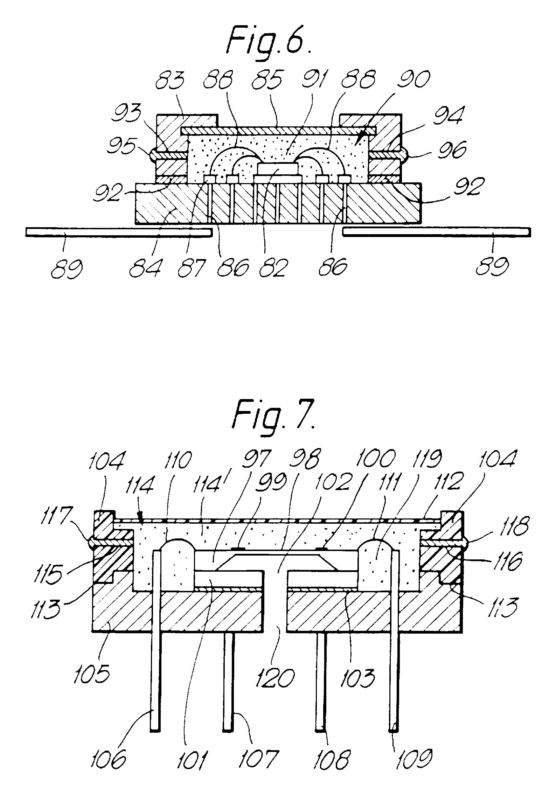

Figs 4-10 are to be described in more detail in order to illustrate a number of typical embodiment examples of the arrangement in the present invention, although these embodiment examples shall not be considered as being, per se, restrictive for the use of the invention.

In fig. 4, a first casing component 43 is shown, preferably made of thermoplastic. The component 43 has a compliant area 44 in the wall of the casing formed during the moulding of said component 43, or optionally formed during the moulding of the component 43 by moulding a compliant, thin metal plate into said component 43. During the moulding of a second casing component 45, a leadframe 46 is moulded therein and a functional device 47 can be attached to a part of the leadframe by means of a binding agent 48. Said functional device 47 forms connections with the electrical conductors 46 by means of wire bonds 49. The securing of said wires 49 to the conductors 46 takes place by means of known wire bonding art, per se.

When the two casing components 43 and 45 are brought together, a junction 50 is formed therebetween where, by means of welding or gluing a seal is formed between said two components 43 and 45.

When said two components 43 and 45 are brought together, there appears therebetween a cavity 51 which may be filled with a filling medium, eg, liquid or solid materials. One example of this is silicone gel. However, other kinds of filler are possible, eg. silicone oil. Holes 52 and 53 are provided to allow for the introduction of the filler 56 into the cavity 51. After the cavity has been filled with filler, said two holes 52 and 53 are sealed as is indicated by the reference numerals 54 and 55. This may take place by means of thermal sealing of the holes, ultrasonic welding, sealing screws, sealing bolts or sealing ball, optionally combined with gaskets. In this connection, the various solutions which are discussed in fig. 3 shall also be referred to. Here, it should be understood that all three solutions in fig. 3 could equally well have been used in connection with the solution in fig. 4.

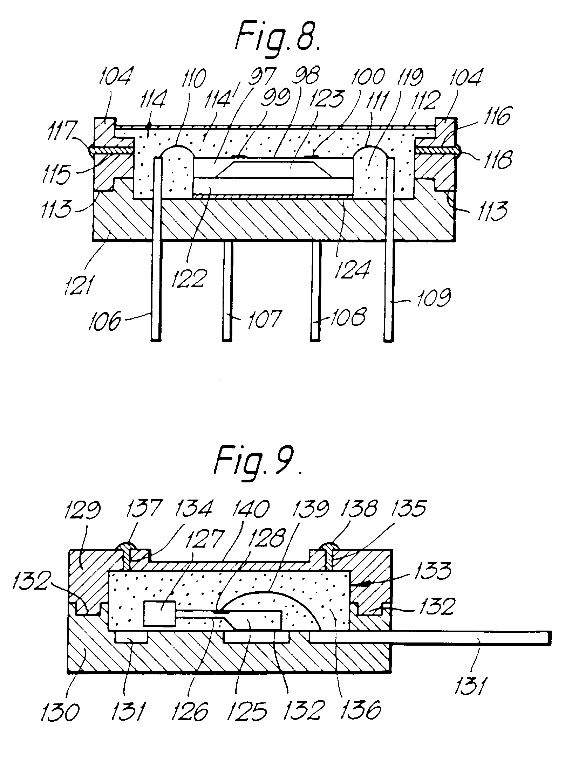

It is obvious, per se, that the filling material which fills the cavity 51 must be of an electrically non-conducting type and with good heat conductive properties if the functional device 47 is a power consuming device where cooling/heat dissipation is necessary, or such that the filler provides the damping of resonance motion in a mass/spring system in the accelerometer. The last-mentioned will be described in more detail in connection with fig. 9. The flexible area 44 of the component 43 which is designed to accommodate heat expansion of the filler 56, may also be made of a thermoplastic material.

Fig. 5 shows a principle for a power-consuming device which is equipped with cooling fins in order to achieve a cooling of the power-consuming functional devices which is as efficient as possible.

The functional devices are here denoted by the reference numerals 57, 58 and 59. These may optionally be attached to the base 60. The casing has a first component 61 and a second component 62. When component 61 is moulded, it is expedient to cast-in a heat conductive component 63 made of, e.g., copper or aluminium, and in the example illustrated, provided with cooling fins. In the second casing component 62, electrical coupling connections 64, 65, 66, 67, 68, 69, 70, 71 have been introduced. These are cast-in into said second component 62 during the moulding thereof. A wire bond from, eg, the conductor 64 to the base 60 occurs by means of a coupling wire 72. In the same way, a connection is made between the conductor 71 and the base 60 by means of a coupling wire 73. If said base 60 is not an integral part of the second component 62, the base 60 may be glued, as is symbolized by reference numeral 74, or bonded in another fashion to the component 62.

The base 60 may be a coupling board with an electronic function, comprising active devices, functional devices 57, 58 and 59, for instance in the form of integrated circuits, and connecting systems (not visible on the drawing). The base or board can comprise a multilayer connecting system, and can, as mentioned, be an integral part of the second casing component 62. For the electrical connections 65, 66, 67, 68, 69, and 70, and for the sake of simplicity, no wire bonds with said base 60 are shown. However, it will be understood that such wire bonds will necessarily be present.

As is explained above, the two casing components 61 and 62 are brought together and thus a junction 75 is formed between the two components. This junction is sealed by welding or by gluing. Between said two components, a cavity 76 is formed which it is desirable to fill with a filling medium which is electrically insulating, e.g., a fluorocarbon. The filling medium 77 is introduced through hole 78 in the upper component 61 and ventilation takes place through hole 79 in the upper component. After cavity 76 has been filled with a filler, said holes 78 and 79 are sealed as is symbolized by reference numerals 80 and 81, and in accordance with one of the methods described hereinbefore.

Fig. 6 illustrates the invention in connection with the use of a circuit board as basis for constructing a cavity casing.

In this case too, there is a first casing component 83 and a second casing component 84 for the functional device 82. Said casing component 84 is, in effect, the circuit board to which the functional device 82 is to be bonded. In the upper casing component 83, a diaphragm may be moulded, e.g., made of metal or the same material, e.g., thermoplastic, as said first casing component 83. The diaphragm in fig. 6 is denoted by the reference numeral 85. In the lower casing component 84, which may be in the form of a circuit board, electrical wire bonds 86 are provided in the form of through-plated holes. These are furnished uppermost with respective contact pads 87. The functional device 82 is connected to said contact pads 87 by means of an electrically conducting wire bond 88. Electrical conductors or contacts 89 conduct away from said through-plated holes. When the upper casing component 83 is placed over the second casing component 84, as is shown in fig. 6, a cavity 90 is formed therebetween. It is desirable to fill this cavity with a filling material, for instance a liquid or a gel substance 91. Said filler 91 may be of any suitable kind whatsoever, eg, as described in connection with the preceding figures.

If the power consumption in the functional device and other possible circuit components, which are on the circuit board 84, is great, said diaphragm 85 may optionally be equipped with cooling fins, as in example 5. A glue 92 may be used as a suitable bonding agent between the upper casing component 83 and the lower casing component 84. In said upper casing component is arranged a set of holes 93 and 94 for the introduction of the filler and ventilation, respectively. After cavity 90 has been filled, said holes 93 and 94 are sealed, as is symbolized by reference numerals 95 and 96, in any one of the ways described in connection with the preceding embodiment examples in figs 1-5.

Figure 7 illustrates a pressure sensor with oil filling wherein a relative measurement of pressure between the top and the bottom of the shown embodiment example, can be made.

A silicon pressure sensor block 97 having a silicon diaphragm 98 is provided. On said block 97 is disposed a set of integrated piezo resistors 99 and 100 produced according to the prior art. By using two resistors, a half bridge is obtained and by using four resistors, a full Wheatstone measuring bridge is achieved. Said block 97 is disposed on a support 101 in such a way as to form a seal. Said support 101 has a central opening 102. The supporting body 101 is via a bonding agent 103 attached to a lower casing component 105. The upper casing component is indicated by the reference numeral 104. In said second or lower casing component 105 is arranged a number of contact pins 106, 107, 108 and 109, of which it will be seen that the contact pins 106 and 109 are connected with formed piece 97 via electrically conductive wire bonds 110 and 111. It will be understood immediately that the metallic conductors 107 and 108 form a corresponding connection with the piece 97 and the resistors 99 and 100 there. For reasons of practicality, these wire bonds are not shown.

The first or upper casing component 104 is equipped with a compliant diaphragm 112 which is an integral part of said first component 104, formed during the moulding thereof, or another compliant material which is mounted during the moulding of said component 104, or attached by means of gluing or any other known technique. When the two components 104 and 105 are brought together, a junction 113 is formed and is sealed by means of gluing or welding, e.g., ultrasonic welding. It is desirable to fill the cavity 114, which is formed between said two components 104 and 105 with diaphragm 112, with an electrically insulating filling material 114', expediently an electrical insulation liquid which fills the entire cavity 114. This occurs by providing horizontal holes 115 and 116 for the introduction of the filling material and ventilation, respectively. When said cavity 114 is full, the holes 115 and 116 are plugged as is symbolized by reference numerals 117 and 118.

This plugging can occur by any one of the methods described in connection with the preceding figures. The electrically insulating liquid has been denoted by the reference numeral 119. As will be apparent from fig. 7, the central opening 102 continues into the second casing cavity 105 in the form of a hole 120, so that, for instance, atmospheric pressure can lie against the lower side of the diaphragm 98. The embodiment in fig. 8 is, in effect, the same as in fig. 7 and with all the same reference numerals as fig. 7, apart from the differences present which are represented by the reference numerals 101, 102, 103, 105 and 120.

In fig. 8, the second or lower casing component is denoted by the reference numeral 121. The support, on which the block 97 rests, is indicated by the reference numeral 122. Between said support 122 and said block 97 with the diaphragm 98 is formed a cavity 123 which will form a pressure reference. In effect, the pressure gauge in fig. 8 thus becomes a sensor for measuring absolute pressure. The support 122 can be attached to the lower casing component 121 by means of glue or another bonding agent 124.

Fig. 9 illustrates the device according to the invention in connection with an accelerometer which has liquid damping. The embodiment in fig. 9 consists of an acceleration-sensitive element 125 with a spring 126 and a mass 127. On said element 125 at said spring 126 a piezo resistor 128 may be arranged which forms a measurement bridge in order to be able to sense movement of the mass 127 during acceleration or retardation. The casing has a first component 129 and a second component 130. In said first component 129 are moulded electric conductors 131, optionally in the form of a leadframe which conducts to the outside of the casing 129, 130. The element 125 may be attached to the leadframe by means of a suitable adhesive 132. When said first component 129 and said second component are brought together for reciprocal engagement, a junction 132 is formed and is sealed by gluing or welding, e.g., ultrasonic welding. Between said first component 129 and said second component 130, a cavity 133 is formed which it is desirable to fill with a liquid filling material. This filling material, e.g., silicone oil, is introduced through a hole 134 in said first component 129 and ventilation occurs through a second hole 135. As soon as the cavity 133 has been filled completely with the filling material, here indicated with the reference numeral 136, the holes 134 and 135 are plugged, as is symbolized by the reference numerals 137 and 138. The method of sealing said holes 134 and 135 can be any one of those which have been shown and described in the preceding figures.

As will be made apparent from fig. 9, there is an electrically conductive wire bond 139 between the sensor element 125 and the electrical conductors 131 which conduct to the outside of the casing.

To be able to accommodate thermal expansion of the liquid 136 in the cavity 133, the first component 129 is equipped with a resilient area 140.

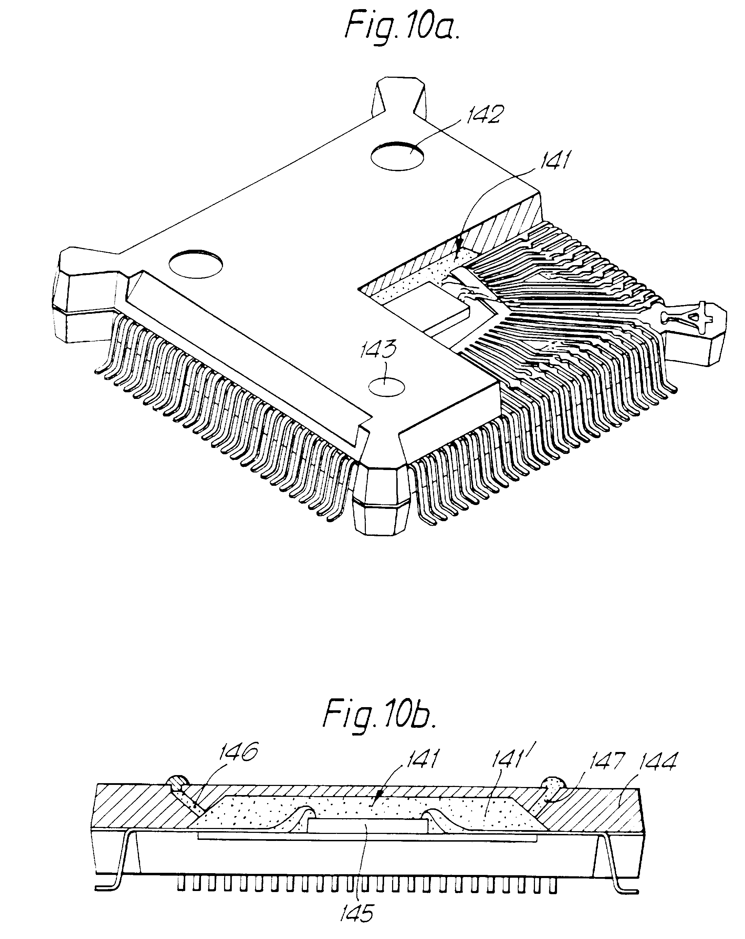

Fig. 10 illustrates, by means of a partly removed area, a large integrated circuit which shows how a multipin casing optionally could be formed. In this solution, a cavity 141 is provided, which may be filled with liquid or another filling material 141' through a hole 142 in the casing, and where ventilation may take place through an second hole 143.

Fig. 10a illustrates how, in a simple way, it is possible to achieve the invention, whilst fig. 10b shows partly in section the liquid-filled cavity 141, the upper casing component 144, and the integrated circuit 145 which is arranged in said cavity 141. The sealing of the filling hole and the ventilation hole are indicated by reference numerals 146 and 147.

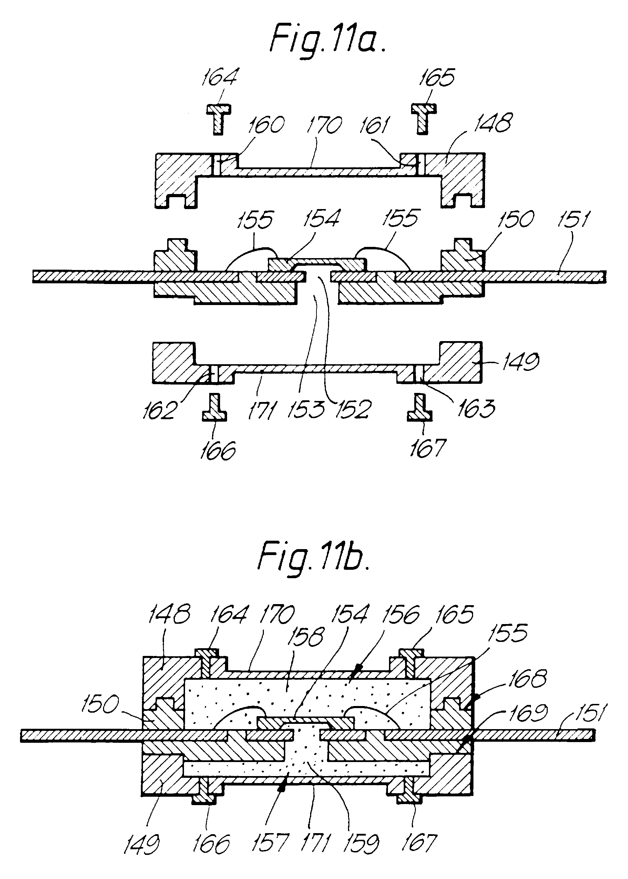

In fig. 11, it is made apparent how the device according to the invention may be used where there is a need for a pressure gauge of the differential kind. The casing consists of a first component 148 and a second component 149 and an intermediate component 150. In the component 150, a lead frame 151 is moulded. A section 152 of the leadframe is opened and furnished with an open part 153 in said component 150. These open parts are closed by a differential pressure gauge 154 which is attached to the leadframe and has wire bonds 155 which form electrical connections with the exterior of the casing via the leadframe 151.

After the components 148, 149 and 150 have been joined together (see fig. 11b), the two cavities 156 and 157 formed are filled with a filling material 158 and 159 respectively, via holes 160, 161, and 162, 163 in components 148 and 149, respectively. The holes are plugged or sealed thereafter, eg, by means of sealing plugs 164, 165 and 166, 167. The joining of the three components at positions 168, and 169 can occur in the same way as explained, for example, in connections with fig. 1 and figs 3-9. There is, of course, nothing to prevent the arrangement in fig. 7 from being formed based on the fundamental principles for fig. 2. Said holes may alternatively be sealed by any one of the methods which have been explained in figs 3a, b, e-h. The thinned parts 170 and 171 of the casing components 148 and 149 serve both to compensate for the expansion of the filling materials 158 and 159, and to transfer pressure to the functional device 154 via said filling materials. From the preceding description, it will be clear that the present invention may be used in many ways, whilst many of the known disadvantages are avoided.

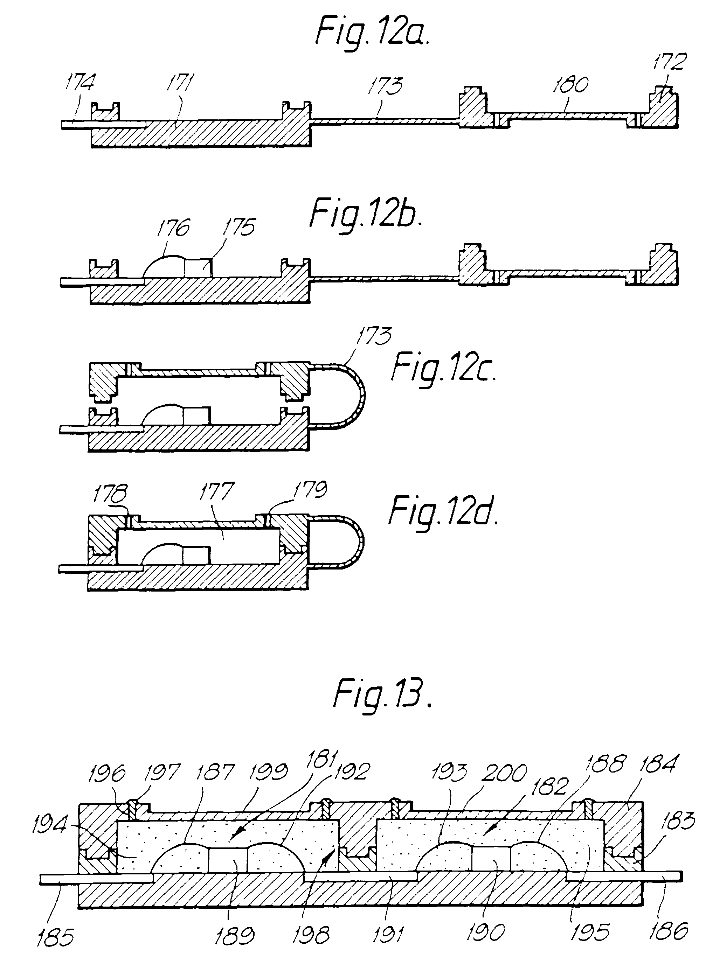

Fig. 12 illustrates how a casing, which to start with is composed of two components 171 and 172, can, in effect, be moulded as a single piece by using a hinge 173. This simplifies the sorting of parts after moulding, especially if the two components would otherwise have been made in the same moulding machine. If the two components would normally have been made in two different moulding machines, production would have been more expensive, even though sorting would not have presented a problem. In fig. 12a, the base component 171 of a casing is shown attached to the upper component 172 of said casing by means of a hinge 173, and where the wire bond 174 is moulded in the base component. In fig. 12b, a functional device 175 is mounted on said base component 171 and connected to the wire bond 174 via wire member 176 in a known way, per se. Thereafter, the top and base components are brought together, as is shown in fig. 12c, and are attached to one another by means of glue or welding, as is shown in fig. 12d. Electrically insulating fluid in the form of a liquid or a gel substance is then introduced into the cavity 177 thus formed via filling holes 178 and 179. The filling holes are sealed as previously described. As described for the preceding embodiments, it is expedient to allow one of the casing components to be equipped with a thinned part 180 which forms an expansion diaphragm.

After mounting, the hinge may optionally be cut away or it may serve as a mounting body for the casing.

Fig. 13 illustrates a variant of the previous embodiments wherein the casing contains two reciprocally physically separated cavities 181 and 182 which are formed by the base component 183 and the top component 184 of the casing. Electrical connections outside and inside the respective cavities occur via respective cast-in conductors 185 and 186, and wherein the connection from said conductors to the adjacent functional device is via respective wire members 187 and 188. In the solution shown here, there is also the possibility of joining the two cavities together by means of wire bond 191 and further to said functional device by means of wire members 192 and 193, respectively. The joining of the top and base components is carried out in the way which has been described previously. Filling the electrically insulating fluid 194 and 195 into cavities 181 and 182, respectively, occurs via filling hole 196 which may be sealed in any one of the previously described ways, eg, by means of a plug 197. In order to deal with possible expansion problems, the top component 184 is furnished with thin-walled parts 199 and 200.

Although the solution in fig 13 is depicted with two cavities, in is within the limits of the taught art, of course, possible to form additional cavities by allowing the top component and the base component to form additional partitions 198.

Although the preceding examples are desribed in particular with the use of leadframes, it shall however, according to the invention, be understood that other highly relevant methods for the formation of electrical conductors are for example the nailing of pins through the plastic material, moulding pins, pressing pins into previously moulded or punched perforations,

through-plated conductors in the base plate of a circuit board, etc. The forms may be thought of as being dual-in-line, flatpack, and unleaded chip-carrier, pin-grid, etc.

## Claims

1. An arrangement for encasing a functional device (1; 47,51-60; 82; 87; 126-128; 145; 154; 175; 189,190), eg, a semiconductor element, a semiconductor-based element, a sensor element, a microactuator, or an electronic circuit consisting of one or more integrated circuits and other electronic components, wherein the casing forms at least one closed cavity (2; 13; 29; 51; 76-90; 114; 133; 141; 156,157; 177; 181,182) which either wholly or partly surrounds the functional device, wherein metal parts (3; 14; 28; 46,64-71; 86; 106-109; 131; 151; 174; 185,186,191) pass through the walls of the casing and form wire bonds to the encased said functional device, and wherein the cavity is sealed and filled with electrically insulating fluid (10; 22; 30; 56; 77; 91; 114' ,136; 141'; 158; 181, 194, 195) characterized in that the casing is made of a plastic material, and in that said plastic material is a thermoplastic, and that at least parts (44; 140; 170; 171; 180; 199,200) of the walls around the cavity are made compliant in order to be able to accommodate expansion forces from said electrically insulating fluid, or that in the cavity there is an inbuilt body (63; 85; 112) in the form of a diaphragm or an elastomer for the accommodation of said expansion forces.

2. An arrangement according to claim 1, is
**charaterized in** that the cavity is sealed by blocking one or more filling holes or ducts (7,8; 18,19; 31,32; 35,37; 39,40; 78,79; 93,94; 115,116; 134,135; 146,147; 160-163; 178,179; 196) after the volume of the cavity has been filled with a liquid and/or gel.

3. An arrangement according to claim 1 or claim 2,
**characterized in** that said electrically insulating fluid is a liquid or a gel material, e.g., a silicone material.

4. An arrangement according to claim 2,
**charaterized in** that said sealing is formed by melting the material around a filling hole (31,32; figs. 3a,3b; 39,49; figs 3e,3f) along a part of the length thereof by means of local application of heat.

5. An arrangement according to one or more of the preceding claims, **characterized in** that the metal parts (3; 14; 28; 46; 131; 151; 174; 185,186; 191) which form the electrical wire bonds through the walls of a casing are formed by a leadframe , e.g. so that the casing is formed as a dual-in-line or single-in-line casing, or by inserting conductive pins (64-71; 106-109) by pressing them through the walls or the side of the casing e.g. so that the casing is formed as a pin-grid array , or that one or more plane sides of the casing are constructed by using a printed circuit board having through-plated conductors (86).

6. An arrangement according to one or more of the preceding claims, **charaterized in** that in said plastic material or polymer material there are inserted, e.g., during moulding, heat sink components (63) which are formed in such as way that the inner surface thereof provides good thermal contact with the liquid or gel in the cavity, and optionally that externally the heat sink component is formed with cooling fins or is attached to a heat sink.

7. An arrangement according to one or more of claims 1 to 5,
**charaterized in** that at least part of the wall of the casing (170,171) is made so as to be resilient and is formed as a diaphragm, said diaphragm being constructed of the same material as the casing, or the diaphragm (112) being constructed in another elastic material and being inserted during a moulding process, a welding process or a gluing process, that the cavity, or cavities, (114; 156; 157) is filled with an electrically insulating liquid (114; 158,159), that the internal functional device (97; 154) contains a pressure-sensitive member which converts pressure signal(s) into electric signal(s), e.g., by said member being piezo-resistant, and that said diaphragm is so elastic that it can transfer pressure from an external pressure medium to said internal liquid and thus to the functional device.

8. An arrangement according to one or more of claims 1 to 7,
**charaterized in** that the functional device contains an acceleration-sensitive member which can convert positive or negative acceleration into an electric signal, e.g., a member consisting of a mass-spring system (125-128) formed with one or more silicon springs (126) with integrated piezo-resistant resistors (128) and a seismic mass (127) arranged around the spring or springs and which gives rise to the springs bending because of the inertia of the mass against said acceleration.

9. An arrangement according to one or more of claims 1 to 5,
**charaterized in** that one part of the wall of the casing is made so as to be compliant and is formed as a diaphragm (112) wherein said diaphragm is of the same material as the casing, or is of another elastic material, flush-mounted, for instance, during a moulding process, a welding process or a gluing process, that the cavity (114) is filled with an electrically insulating liquid (114'), that the internal functional device contains a pressure-sensitive member (97) which converts a pressure signal into an electrical signal, e.g., by the member being piezo-resistant, and that said diaphragm is so elastic that the elastic forces thereof make a small addition to the pressure in the internal liquid relative to the pressure which the mass of the liquid creates when the arrangement is subjected to positive or negative acceleration, external pressure or to the effect of another force.

10. An arrangement according to claim 7 or claim 9,
**charaterized in** that one side of the pressure-sensitive part (98) of the functional device (97) either communicates with the exterior of the casing via openings (102, 120) in a supporting body (101) for the functional device (97) and the adjacent part of the casing (105), respectively, or is adjacent to a cavity (123) formed by the functional device and the supporting body (122) thereof.

11. An arrangement according to one or more of claims 1 to 5,
**charaterized in** that parts (170, 171) of the wall of the casing, on opposite plane sides of said casing are made so as to be compliant and each is formed as a diaphragm, a diaphragm of this kind being of the same material as the casing, or said diaphragm being of another elastic material and being inserted, e.g., during a moulding process, a welding process or a gluing process, that the functional device (154) together with the casing (148, 149, 150) forms two cavities (156, 157), each adjacent to one of said diaphragm, that each of the cavities is filled with an electrically insulating liquid (158, 159), that the internal functional device (154) contains a pressure-sensitive member which converts a differential pressure signal passed on by said two diaphragm as an electric signal, e.g., by the said member being piezo-resistant, and that said diaphragms (170,171) are so elastic that the elastic forces thereof make a small addition to the pressure in the internal liquid relative to the pressure which the mass of the liquid or gel in said cavities cause when it is subjected to pressure or the effect of another force.

12. An arrangement according to one or more of the preceding claims, **charaterized in** that the casing consists of two (5,6; 16,17; 25,26; 43,45; 61,62; 83,84; 104,105; 129,130; 171,172; 183,184) or more (148,149,150) components which may be joined together.

13. An arrangement according to claim 12,
**charaterized in** that said joinable components (171,172) are moulded as one single piece, the adjacent components being joined to one another by means of a hinge member (173) made of the same plastic material as said two components.

14. An arrangement according to claim 12 or claim 13,
**charaterized in** that the number of cavities in the casing is N - 1, or N + n, where N is the number of joinable components of which the casing consists and n = 1, 2, 3, 4....., etc.

15. An arrangement according to claim 14,
**charaterized in** that the number of cavities is two or more, wherein there is an electrical connection (191) between said cavities.

16. An arrangement according to claim 14,
**characterized in** that said electrical connection (191) is formed in the component (183) of the casing in which the other electrical connections (185,186) to the cavities are formed.

17. An arrangement according to one or more of the preceding claims, **characterized in** that said metal parts are located in two (fig. 11) of the casing components.

18. A process for encasing a functional device, e.g., a semiconductor element, a semiconductor-based element, a sensor element, a microactuator or an electronic circuit consisting of one or more integrated circuits and other electronic components, wherein the casing around the functional device is formed by two or more components (5,6; 16,17; 25,26; 43, 45; 61,62; 83,84; 104,105; 129,130; 148-150; 171,172; 183,184) which when joined together form at least one cavity (2; 13; 29; 51; 76; 90; 114; 133; 141; 156,157; 177; 181,182), wherein in one or more of said components or between two of the components are built in electrical conductors (3; 14; 28; 46,64-71; 86; 106-109; 131; 151; 174; 185,186, 191) of metal, e.g., a leadframe which has a part which projects outside the casing when the components have been joined together, wherein a functional device (1; 47; 57-60; 82; 97; 125-128; 145; 154; 175; 189,190) is attached to the side of the cavity prior to the components being joined together, wherein electrical terminals on the functional device are attached to the respective electrical conductors within the area of the cavity prior to the components being joined together, wherein the components are joined together in such a way as to be sealed, eg, by gluing or welding, wherein electrically insulating fluid (10; 22; 30; 56; 77; 91; 114' ,136; 141'; 158,159; 194, 195) is introduced into the cavity or cavities through filling holes (7,8; 18,19; 31,32; 35,37; 39,40; 52,53; 78,79; 93,94; 115,116; 134,135; 146,147; 160-163; 178,179; 196) in an adjacent part of the casing, and wherein the filling holes are plugged in such a way that the cavity is sealed, and becomes tight, characterized in that the casing components are made of a thermoplastic material, and that at least parts (44; 140; 170; 171; 180; 199,200) of the walls around the cavity are made so as to be resilient for the accommodation of expansion forces from said electrically insulating fluid, or in that a body (63; 85; 112) is built into the cavity in the form of a diaphragm or an elastomer for the accommodation of said expansion forces.

19. A process according to claim 18,
**characterized in** that the filling holes are sealed by means of thermal welding or friction welding (figs. 3a,3b; figs 3e,3f).

20. A process acording to claim 19,
**characterized in** that said thermal welding takes place by means of the local application of heat around said filling holes, e.g., by means of a welding iron.

21. A process according to claim 18,
**characterized in** that said filling hole is sealed by means of sealing screw or screws, sealing bolt or bolts (figs 3c, 3d) or sealing ball or balls (figs 3g, 3h), optionally in combination with accompanying gasket.

22. A process according to claim 17,
**characterized in** that the joinable components of the casing are press moulded in a single piece and in such a way that a bendable hinge is formed between the adjacent moulded components.

## Patentansprüche

1. Anordnung zur Gehäusebildung um eine Funktionseinrichtung (1; 47;51-60; 82; 87; 126-128; 145; 154; 175; 189,190), z.B. um ein Halbleiterelement, ein auf einem Halbleiter basierendes. Element, ein Sensorelement, ein Mikrostellglied oder eine elektronische Schaltung bestehend aus einer oder meheren integrierten Schaltungen und andere elektrorische Bauteile, wobei das Gehäuse mindestens einen verschlossenen Hohlraum (2; 13; 29; 51, 76-90; 114; 133; 141; 156, 157; 177; 181, 182) bildet, der die Funktionseinrichtung entweder ganz oder teilweise umgibt, wobei Metallteile (3; 14; 28; 46,64-71; 86; 106-109; 131; 151; 174; 185, 186,191) durch die Wande des Gehäuses verlaufen und Drahtverbindungen zu der vom Gehäuse umgebenen Funktionseinrichtung bilden, und wobei der Hohlraum abgedichtet und mit einem elektrisch isolierenden Fluid (10; 22; 30; 56; 77; 91; 114', 136; 141' ; 158 ; 181, 194, 195) gefüllt ist, dadurch gekennzeichnet, daß das Gehäuse aus einer Kunststoff-Formmasse hergestellt und die Kunststoff-Formmasse ein Thermoplast ist, und daß zumindest Teile (44; 140; 170; 171; 180; 199,200) der den Hohlraum umgebenden Wände nachgiebig gestaltet sind, um Expansionskräfte des elektrisch isolierenden Fluids aufzunehmen, oder in dem Hohlraum zur Aufnahme dieser Expansionskräfte ein, eingebauter Körper (63; 85; 112) in Form, einer Membran oder eines Elastomers vorgesehen ist.

2. Anordnung nach Anspruch 1, dadurch gekennzeichnet, daß der Hohlraum durch Blockieren einer oder mehrerer Fullöffnungen oder Durchführungen (7,8; 18,19; 31,32 ; 35,37; 39,40; 78,79; 93,94; 115,116; 134,135; 146,147; 160-163; 178,179; 196) abgedichtet ist, nachdem das Hohlraumvolumen mit einer Flüssigkeit und/oder einem Gel gefüllt wurde.

3. Anordnung nach Anspruch 1 oder Anspruch 2, dadurch gekennzeichnet, daß das elektrisch isolierende Fluid eine Flüssigkeit oder ein Gelmaterial, z.B. ein Silikonmaterial ist.

4. Anordnung nach Anspruch 2, dadurch gekennzeichnet, daß die Abdichtung durch Schmelzen des Materials um die Fullöffnung (31,32; Figuren 3a,3b; 39,49; Figuren 3e,3f) herum entlang eines Teils seiner Länge mittels örtlicher Warmeanwendung gebildet ist.

5. Anordnung nach einem oder mehreren der vorangehenden Ansprüche, dadurch gekennzeichnet, daß die Metallteile (3; 14; 28; 46; 131; 151; 174; 185,186; 191), welche die elektrischen Drahtvarbindungen durch die Wände eines Gehäuses bilden, durch einen Anschlußrahmen gebildet sind, z.B. so, daß das Gehaüse als Dual-in-line Gehäuse oder Single-in-line Gehäuse ausgebildet ist, oder durch Einsetzen leitender Stifte (64-71; 106-109) gebildet sind, die durch die Wände oder die Seiten des Gehäuses gepreßt sind, z.B, so, daß das Gehäuse als Stiftgitter-Anordnung ausgebildet ist, oder daß eine oder mehrere ebene Seiten des Gehaüses durch Verwendung einer Leiterplatte gestaltet sind, die durchkontaktierte Leiter (86) aufweist.

6. Anordnung nach einem oder mehreren der vorangehenden Ansprüche, dadurch gekennzeichnet, daß in die KunststoffFormmasse oder das Polymermaterial, z.B. während des Formens, Kühlkörper-Bauteile (63) eingesetzt werden, die in der Weise ausgestaltet sind, daß deren Innenfläche einen guten Wärmekontakt mit der Flüssigkeit oder dem Gel in dem Hohlraum schafft, und wahlweise, daß das Kühlkörper-Bauteil außen mit Kühlrippen ausgebildet oder an einem Kühlkörper angeschlossen ist.

7. Anordnung nach einam oder mehreren der Ansprüche 1 bis 5, dadurch gekennzeichnet, daß zumindest ein Teil der Gehausewand (170,171) elastisch und als Membran ausgebildet ist, die aus dem gleichen Material wie das Gehäuse ausgeführt ist, oder die Membran (112) aus einem anderen elastischen Material ausgeführt ist und während eines Gießvorgangs, eines Schweißvorgangs oder eines Klebevorgangs eingesetzt wird, daß der Hohlraum oder die Hohlräume (114; 156; 157) mit einer elektrisch isolierenden Flüssigkeit (114; 158,159) gefüllt sind, daß die innenliegende Funktionseinrichtung (97; 154) ein druckempfindliches Element enthält, das (ein) Drucksignal(e) in (ein) elektrische(s) Signal(e) umwandelt, z.B. indem das Element piezoresistiv ist, und daß die Membran so elastisch ist, daß sie Druck von einem äußeren Druckmittel auf die innere Flüssigkeit und somit auf die Funktionseinrichtung übertragen kann.

8. Anordnung nach einem oder mehreren der Ansprüche 1 bis 7, dadurch gekennzeichnet, daß die Funktionseinrichtung ein beschleunigungsempfindliches Element enthält, das eine positive oder negative Beschleunigung in ein elektrisches signal umwandeln kann, z.B. ein Element, das aus einem Federmassen-System, (125-128) besteht, das aus einer oder mehreren Silikonfedern (126) mit integrierten piezoresistiven Widerständen (128) und einer um die Feder oder Federn herum angeordneten seismischen Masse (127) gebildet ist und aufgrund, der Massenträgheit gegenüber der Beschleunigung eine Federkrummung hervorruft.

9. Anordnung nach einem oder mehreren der Ansprüche 1 bis 5, dadurch gekennzeichnet, daß ein Teil der Gehäüsewand nachgiebig und als Membran (112) ausgebildet ist, wobei die Membran aus dem gleichen Material wie das Gehäuse oder einem anderen elastischen Material besteht und darin zum Beispiel während eines Gießvorgangs, eines Schweißvorgangs oder eines Klebevorgangs versenkt eingebaut wird, daß der Hohlraum (114) mit einer elektrisch isolierenden Flüssigkeit (114') gefüllt ist, daß die innenliegende Funktionseinrichtung ein druckempfindliches Elememt (97) enthält, das ein Drucksignal in ein elektrisches Signal umwandelt, z.B. indem das Element piezorezistiv ist, und daß die Membran so elastisch ist, daß deren elastische Kräfte einen kleinen Druckzuwachs in der inneren Flüssigkeit gegenüber dem Druck erzeugen, den die Flüssigkeitsmasse erzeugt, wenn die Anordnung einer positiven oder neqativen Beschleunigung, einem, äußeren Druck oder dem Einfluß einer anderen Kraft ausgesetzt wird.

10. Anordnung nach anspruch 7 oder Anspruch 9, dadurch gekennzeichnet, daß eine Seite des druckempfindlichen Teils (98) der Funktionseinrichtung (97) entweder mit der Außenseite des Gehauses uber Offnungen (102, 120) in einem Stützkörper (101) für die Funktionseinrichtung (97) und einem angrenzenden Teil des Gehäuses (105) in Verbindung steht oder an einen Hohlraum (123) angrenzt, der durch die Funktionseinrichtung und dessen Stutzkörper (122) gebildet ist.

11. Anordnung nach einem oder mehreren der Ansprüche 1 bis 5, dadurch gekennzeichnet, daß Teile (170, 171) der Gehäusewand an gegenuberliegenden, ebenen Seiten des Gehäuses nachgiebig und jeweils als Membran ausgebildet sind, wobei eine derartige Membran aus dem gleichen Material wie das Gehäuse oder einem anderen elastischen Material besteht und z.B. während eines Gießvorgangs, eines Schweißvorgangs oder eines Klebevorgangs eingesetzt wird, daß die Funktionseinrichtung (154) zusammen mit dem Gehäuse (148, 149, 150) zwei Hohlräume (156, 157) bildet, die jeweils an eine der Membranen angrenzen, däß jeder der Hohlraume mit einer elektrisch isolierenden Flüssigkeit (158, 159) gefüllt ist, daß die innenliegende Funktionseinrichtung (154) ein druckempfindliches Element enthält, das ein Differentialdrucksignal, welches durch die zwei Membranen aufgenommen wird, als elektrisches Signal umwandeit, z.B. indem das Element piezoresistiv ist, und daß die Membranen (170, 171) so elastisch sind, daß deren elastische Kräfte einen kleinen Druckzuwachs in der inneren Flüssigkeit gegenüber dem Druck erzeugen, den die Flüssigkeitsmasse oder die Gelmasse in den Hohlräumen hervorruft, wenn sie einem Druck oder dem Einfluß einer anderen Kraft ausgesetzt wird.

12. Anordnung nach einem oder mehreren der vorangehenden Ansprüche, dadurch gekennzeichnet, daß das Gehäuse aus zwei (5,6; 16,17; 25,26; 43,45; 61,62; 83,84; 104,105; 129,130; 171,172; 183,184) oder mehreren (148,149,150) Bestandteilen besteht, die miteinander verbunden werden können.

13. Anordnung nach Anspruch 12, dadurch gekennzeichnet, daß die verbindbaren Bestandteile (171,172) als ein Einzelteil gegossen werden, die aneinanderliegenden Bestandteile mittels einem Gelenkelement (173) verbunden sind, das aus der gleichen Kunststoff-Formmasse wie die zwei Bestandteile hergestellt ist.

14. Anordnung nach Anspruch 12 oder Anspruch 13, dadurch gekennzeichnet, daß die Anzahl der Hohlräume in dem Gehäuse N - 1 oder N + n beträgt, wobei N die Anzahl der verbindbaren Bestandteile ist, aus denen das Gehäuse besteht, und n = 1, 2, 3, 4, ...., USW. ist.

15. Anordnung nach Anspruch 14, dadurch gekennzeichnet, daß die Anzahl der Hohlräume zwei oder mehr beträgt, wobei zwischen den Hohlräumen eine elektrische Verbindung (191) vorhanden ist.

16. Anordnung nach Anspruch 14, dadurch gekennzeichnet, daß die elektrische Verbindung (191) in dem Bestandteil (183) des Gehauses ausgebildet ist, in welchem die anderen elektrischen Verbindungen (185,186) zu den Hohlräumen ausgebildet sind,

17. Anordnung nach einem oder mehreren der vorangehenden Anspruche, dadurch gekennzeichnet, daß die Metallteile in zwei. der Gehausebestandteile (Fig, 11) angeordnet sind.

18. Verfahren zur Gehäusebildung um eine Funktionseinrichtung, z.B. um ein Halbleiterelement, ein auf einem Halbleiter basierendes Element, ein Sensorelement, ein Mikrostellglied oder eine elektronische Schaltung bestehend aus einer oder mehreren integrierten schaltungen und andere elektronische Bauteile, wobei das die Funktionseinrichtung umgebende Gehäuse durch zwei oder mehr Bestandteilen (5,6; 16,17; 25,26; 43, 45; 61,62; 83,84; 104,105; 129,130; 148-150; 171,172; 183,184) gebildet wird, die beim Zusammensetzen zumindest einen Hohlraum bilden (2; 13; 29; 51; 76; 90; 114; 133; 141; 156, 157; 177, 181,182), wobei in einem oder mehreren der Bestandteile oder zwischen zwei der Bestandteilen elektrische Leiter (3; 14; 28; 46/64-71; 86; 106-109; 131; 151; 174; 185, 186, 191) aus Metall eingebaut sind, z.B. ein Anschlußrahmen, der ein Teilstück aufweist, das am Gehäuse außen absteht, wenn die Bestandteile zusammengefügt wurden, wobei die Funktionseinrichtung (1; 47; 57-60; 82; 97; 125-128; 145; 154; 175; 169,190) an der Seite des Hohlraums angebracht wird, bevor die Bestandteile zusammengefügt werden, wobei elektrische Anschlußklemmen an der Funktionseinrichtung innerhalb des Hohlraumbereichs an den jeweiligen elektrischen Leitern angebracht werden, bevor die Bestandteile zusammengefügt werden, wobei die Bestandteile in der Weise zusammengefügt werden, daß sie abgedichtet sind, z.B. durch Verkleben oder Verschwißen, wobei ein electrisch isolierendes Fluid (10; 22; 30; 56; 77; 91; 114', 136; 141'; 158,159; 194, 195) durch Füllöffnungen (7,8; 18,19; 31,32; 35,37; 39,40; 52,53; 78,79; 93,94; 115,116; 134, 135; 146,147; 160-163; 178,179; 196) in den oder die Hohlräume in einen angrenzendern Teil des Gehäuses eingeführt wird, und wobei die Füllöffnungen in der Weise zugestopft werden, daß der Hohlraum abgeschlossen und dicht ist, dadurch gekennzeichnet, daß die Gehäusebestandteile aus thermoplastischem Material hergestellt und zumindest Teile (44; 140; 170; 171; 180; 199,200) der den Hohlraum umgebenden Wände nachgiebig gestaltet werden, um Expansionskräfte des elektrisch isolierenden Fluids aufzunehmen, oder daß ein Körper (63; 85; 112) in Form einer Membran oder eines Elastomers zur Aufnahme dieser Expansionskräfte in dem Hohlraum eingebaut wird.

19. Verfahren nach Anspruch 18, dadurch gekennzeichnet, daß die Fullöffnungen durch thermisches Schweißen oder Reibungsschweißen abgedichtet werden.

20. Verfahren nach Anspruch 19, dadurch gekennzeichnet, daß das thermische Schweißen durch örtliche Wärmeanwendung um die Füllöffnungen erfolgt, z.B. mittels eines Schweißeisens.

21. Verfahren nach Anspruch 18, dadurch gekennzeichnet, daß die Füllöffnung mittels einer Dichtungsschraube oder -shrauben, einem Dichtungsbolzen oder mehrerer Dichtungsbolzen (Figuren 3c, 3d) oder einer Dichtungskugel oder -kugeln (Figuren 3g, 3h) abgedichtet werden, wahlweise in Kombination mit einer verbundenen Dichtung.

22. Verfahren nach Anspruch 17, dadurch gekennzeichnet, daß die verbindbaren Bestandteile des Gehäuses als Einzelteil und in der Weise preßgeformt sind, daß zwischen den benachbart zueinander geformten Bestandteilen ein biegbares Gelenkband ausgebildet wird.

## Revendications

1. Ensemble de mise en boîtier d'un dispositif fonctionnel (1 ; 47, 51-60 ; 82 ; 87 ; 126-128 ; 145 ; 154 ; 175 ; 189, 190), par exemple un élément à semi-conducteur, un élément à base de semi-conducteur, un élément capteur, un micro-actionneur ou un circuit électronique constitué d'un ou plusieurs circuits intégrés et d'autres composants électroniques, dans lequel le boîtier forme au moins une cavité fermée (2 ; 13 ; 29 ; 51 ; 76-90 ; 114 ; 133 ; 141 ; 156, 157 ; 177 ; 181, 182) qui entoure en totalité ou en partie le dispositif fonctionnel, dans lequel des parties métalliques (3 ; 14 ; 28 ; 46, 64-71 ; 86 ; 106-109 ; 131 ; 151 ; 174 ; 185, 186, 191) traversent les parois du boîtier et forment des liaisons par fils avec le dispositif fonctionnel placé dans le boîtier, et dans lequel la cavité est scellée et remplie par un fluide isolant de l'électricité (10 ; 22 ; 30 ; 56 ; 77 ; 91 ; 114', 136 ; 141' ; 158 ; 181, 194, 195), caractérisé en ce que le boîtier est formé d'une matière plastique, et en ce que la matière plastique est une matière thermoplastique et en ce que des parties au moins (44 ; 140 ; 170 ; 171 ; 180 ; 199, 200) des parois entourant la cavité sont formées afin qu'elles soient souples de manière qu'elles permettent la compensation des forces de dilatation du fluide isolant de l'électricité ou en ce qu'un corps incorporé (63 ; 85 ; 112) est placé dans la cavité sous forme d'un diaphragme ou d'un élastomère destiné à compenser les forces de dilatation.

2. Ensemble selon la revendication 1, caractérisé en ce que la cavité est fermée de manière étanche par bouchage d'un ou plusieurs conduits ou orifices de remplissage (7, 8 ; 18, 19 ; 31, 32 ; 35, 37 ; 39, 40 ; 78, 79 93, 94 ; 115, 116 ; 134, 135 ; 146, 147 ; 160-163 ; 178, 179 ; 196) après que le volume de la cavité a été rempli d'un liquide et/ou d'un gel.

3. Ensemble selon la revendication 1 ou 2, caractérisé en ce que le fluide isolant de l'électricité est un liquide ou une matière sous forme d'un gel, par exemple une matière à base de silicone.

4. Ensemble selon la revendication 2, caractérisé en ce que le scellement est formé par fusion de la matière autour d'un trou de remplissage (31, 32 figures 3a, 3b ; 39, 49 ; figures 3e, 3f) sur une partie de la longueur par application locale de chaleur.

5. Ensemble selon une ou plusieurs des revendications précédentes, caractérisé en ce que les parties métalliques (3 ; 14 ; 28 ; 46 ; 131 ; 151 ; 174 ; 185, 186 ; 191) qui forment les liaisons par fils électriques traversant les parois d'un boîtier sont formées par un cadre à fils de connexion, par exemple de manière que le boîtier soit sous forme d'un boîtier à deux lignes de connexion ou une seule ligne de connexion, ou par insertion de broches conductrices (64-71 ; 106-109) par application d'une pression pour le passage à travers les parois ou le côté du boîtier, par exemple de manière que le boîtier soit formé d'un réseau à broches et grille, ou qu'un ou plusieurs côtés plans du boîtier soient réalisés par utilisation d'une carte de circuit intégré ayant des conducteurs dans des trous revêtus (86).

6. Ensemble selon une ou plusieurs des revendications précédentes, caractérisé en ce que, à l'intérieur de la matière plastique ou de la matière polymère, des éléments de radiateur (63) sont insérés par exemple pendant le moulage et sont formés de manière que leur surface interne donne un bon contact thermique avec le liquide ou le gel présent dans la cavité et éventuellement qu'un élément de radiateur soit réalisé à l'extérieur avec des ailettes de refroidissement ou soit fixé à un radiateur.

7. Ensemble selon une ou plusieurs des revendications 1 à 5, caractérisé en ce qu'une partie au moins de la paroi du boîtier (170, 171) est formée afin qu'elle soit élastique et constitue un diaphragme, le diaphragme ayant une construction formée du même matériau que le boîtier, ou le diaphragme (112) étant construit en une autre matière élastique et étant introduit au cours d'une opération de moulage, d'une opération de soudage ou d'une opération de collage, en ce que la cavité ou les cavités (114 ; 156 ; 157) sont remplies d'un liquide isolant de l'électricité (114 ; 158 ; 159), en ce que le dispositif fonctionnel interne (97 ; 154) contient un organe manosensible qui transforme un ou plusieurs signaux de pression en un ou plusieurs signaux électriques, par exemple parce que l'organe est piézorésistant, et en ce que le diaphragme a une élasticité telle qu'il peut transférer la pression d'un fluide externe sous pression au liquide interne et ainsi au dispositif fonctionnel.

8. Ensemble selon une ou plusieurs des revendications 1 à 7, caractérisé en ce que le dispositif fonctionnel contient un organe sensible à l'accélération et qui peut transformer une accélération positive ou négative en un signal électrique, par exemple un organe constitué d'un système masse-ressort (125-128) formé avec un ou plusieurs ressorts de silicium (126) avec des résistances piézorésistantes intégrées (128), et une masse sismique (127) placée autour du ressort ou des ressorts et qui provoque une flexion des ressorts à cause de l'inertie de la masse soumise à l'accélération.

9. Ensemble selon une ou plusieurs des revendications 1 à 5, caractérisé en ce qu'une première partie de la paroi du boîtier est réalisée afin qu'elle soit souple et est formée par un diaphragme (112), le diaphragme étant formé de la même matière que le boîtier, ou étant formé d'une autre matière élastique placée de niveau, par exemple pendant une opération de moulage, une opération de soudage ou une opération de collage, en ce que la cavité (114) est remplie d'un liquide isolant de l'électricité (114'), en ce que le dispositif fonctionnel interne contient un organe manosensible (97) qui transforme un signal de pression en un signal électrique, par exemple parce que l'organe est piézorésistant, et en ce que le diaphragme a une élasticité telle que les forces élastiques forment une petite augmentation de la pression du liquide interne par rapport à la pression que crée la masse du liquide lorsque l'ensemble est soumis à une accélération positive ou négative, une pression extérieure ou à l'effet d'une autre force.

10. Ensemble selon la revendication 7 ou 9, caractérisé en ce qu'un premier côté de la partie manosensible (98) du dispositif fonctionnel (97) soit communique avec l'extérieur du boîtier par des ouvertures (102, 120) formées dans le corps de support (101) du dispositif fonctionnel (97) et de la partie adjacente du boîtier (105), soit est adjacent à une cavité (123) formée par le dispositif fonctionnel et son corps de support (122).

11. Ensemble selon une ou plusieurs des revendications 1 à 5, caractérisé en ce que des parties (170, 171) de la paroi du boîtier, sur les côtés plans opposés du boîtier, sont formées afin qu'elles soient souples et constituées chacune par un diaphragme, un diaphragme de ce type étant formé de la même matière que le boîtier ou le diaphragme étant formé d'une autre matière élastique et étant introduit, par exemple pendant une opération de moulage, une opération de soudage ou une opération de collage, en ce que le dispositif fonctionnel (154) avec le carter (148, 149, 150) forme deux cavités (156, 157) adjacentes chacune à l'un des diaphragmes, en ce que chaque cavité est remplie d'un liquide isolant de l'électricité (158, 159), en ce que le dispositif fonctionnel interne (154) contient un organe manosensible qui transforme un signal différentiel de pression transmis par deux diaphragmes en un signal électrique, par exemple parce que ledit organe est piézorésistant, et en ce que les diaphragmes (170, 171) ont une élasticité telle que les forces élastiques qui leur sont appliquées augmentent faiblement la pression du liquide interne par rapport à la pression que crée la masse du liquide ou du gel dans les cavités lorsqu'elle est soumise à la pression ou à l'effet d'une autre force.

12. Ensemble selon une ou plusieurs des revendications précédentes, caractérisé en ce que le boîtier comprend deux éléments (5, 6 ; 16, 17 ; 25, 26 ; 43, 45 ; 61, 62 ; 83, 84 ; 104, 105 ; 129, 130 ; 171, 172 ; 183, 184) ou plusieurs éléments (148, 149, 150) qui peuvent être raccordés.

13. Ensemble selon la revendication 12, caractérisé en ce que les éléments (171, 172) qui peuvent être raccordés sont moulés en une seule pièce, les éléments adjacents étant raccordés mutuellement par un organe d'articulation (173) formé de la même matière plastique que les deux éléments.

14. Ensemble selon la revendication 12 ou 13, caractérisé en ce que le nombre de cavités dans le boîtier est égal à N - 1 ou N + n, N étant le nombre d'éléments qui peuvent être raccordés et dont est formé le boîtier, avec n = 1, 2, 3, 4, ...

15. Ensemble selon la revendication 14, caractérisé en ce que le nombre de cavités est supérieur ou égal à deux, et il existe une connexion électrique (191) entre les cavités.

16. Ensemble selon la revendication 14, caractérisé en ce que la connexion électrique (191) est formée dans l'élément (183) du boîtier dans lequel les autres connexions électriques (185, 186) aux cavités sont formées.

17. Ensemble selon une ou plusieurs des revendications précédentes, caractérisé en ce que les parties métalliques sont disposées dans deux des éléments du boîtier (figure 11).

18. Procédé de mise en boîtier d'un dispositif fonctionnel, par exemple un composant à semi-conducteur, un élément à base d'un semi-conducteur, un composant capteur, un micro-actionneur ou un circuit électrique constitué d'un ou plusieurs circuits intégrés ou d'autres composants électroniques, dans lequel le boîtier placé autour du dispositif fonctionnel est formé par au moins deux éléments constituants (5, 6 ; 16, 17 ; 25, 26 ; 43, 45 ; 61, 62 ; 83, 84 ; 104, 105 ; 129, 130 ; 148-150 ; 171, 172 ; 183, 184) qui, lorsqu'ils sont raccordés, forment au moins une cavité (2 ; 13 ; 29 ; 51 ; 76 ; 90 ; 114 ; 133 ; 141 ; 156, 157 ; 177 ; 181, 182), dans lequel, dans un ou plusieurs des éléments constituants ou entre deux de ces éléments constituants, des conducteurs électriques métalliques (3 ; 14 ; 28 ; 46, 64-71 ; 86 ; 106-109 ; 131 ; 151 ; 174 ; 185, 186, 191) sont incorporés, par exemple sous forme d'un cadre à fils de connexion qui possède une partie qui dépasse à l'extérieur du boîtier lorsque les éléments constituants ont été raccordés, dans lequel un dispositif fonctionnel (1 47 ; 57-60 ; 82 ; 97 ; 125-128 ; 145 ; 154 ; 175 ; 189, 190) est fixé au côté de la cavité avant que les éléments constituants ne soient raccordés les uns aux autres, dans lequel des bornes électriques du dispositif fonctionnel sont fixées aux conducteurs électriques respectifs placés dans la région de la cavité avant que les éléments constituants ne soient raccordés, dans lequel les éléments constituants sont raccordés les uns aux autres afin qu'ils soient fixés de manière étanche, par exemple par collage ou soudage, dans lequel un fluide isolant de l'électricité (10 ; 22 ; 30 ; 56 ; 77 ; 91 ; 114', 136 ; 141' ; 158, 159 ; 194 ; 195) est introduit dans la cavité ou les cavités par des trous de remplissage (7, 8 ; 18, 19 ; 31, 32 ; 35, 37 ; 39, 40 ; 52, 53 ; 78, 79 ; 93, 94 ; 115, 116 134, 135 ; 146, 147 ; 160-163 ; 178, 179 ; 196) dans une partie adjacente du boîtier, et dans lequel les trous de remplissage sont bouchés de manière que la cavité soit scellée et devienne étanche, caractérisé en ce que les éléments constituants du boîtier sont formés d'une matière thermoplastique, et en ce que des parties au moins (44 ; 140 ; 170 ; 171 ; 180 ; 199, 200) des parois placées autour de la cavité sont formées afin qu'elles soient élastiques et permettent la compensation des forces de dilatation du fluide isolant de l'électricité, ou en ce que le corps (63 ; 85 ; 112) est incorporé dans la cavité sous forme d'un diaphragme ou d'un élastomère destiné à compenser les forces de dilatation.

19. Procédé selon la revendication 18, caractérisé en ce que les trous de remplissage sont scellés par soudage thermique ou soudage par friction (figures 3a, 3b ; figures 3e, 3f).

20. Procédé selon la revendication 19, caractérisé en ce que le soudage thermique est réalisé par application locale de chaleur autour des trous de remplissage, par exemple par un fer à souder.

21. Procédé selon la revendication 18, caractérisé en ce que le trou de remplissage est scellé par une ou plusieurs vis de scellement, un ou plusieurs boulons de scellement (figures 3c, 3d) ou une ou plusieurs billes de scellement (figures 3g, 3h), éventuellement en combinaison avec une garniture associée.

22. Procédé selon la revendication 17, caractérisé en ce que les éléments constituants du boîtier qui peuvent être raccordés sont moulés à la presse en une seule pièce et de manière qu'une articulation flexible soit formée entre les éléments moulés adjacents.
